Europäisches Patentamt

**European Patent Office**

**Office européen des brevets**

(19)

(11) Veröffentlichungsnummer: **0 088 910**
**B1**

(12) # EUROPÄISCHE PATENTSCHRIFT

(45) Veröffentlichungstag der Patentschrift:
10.07.85

(51) Int. Cl.⁴: **H 02 K 11/00, H 01 R 4/00**

(21) Anmeldenummer: 83101686.0

(22) Anmeldetag: 22.02.83

(54) Drehstromgenerator mit Dreiphasengleichrichter für Fahrzeuge.

(30) Priorität: 12.03.82 DE 3208893

(43) Veröffentlichungstag der Anmeldung:
21.09.83 Patentblatt 83/38

(45) Bekanntmachung des Hinweises auf die Patenterteilung:
10.07.85 Patentblatt 85/28

(84) Benannte Vertragsstaaten:
DE FR GB

(56) Entgegenhaltungen:
DE - C - 1 086 318
DE - U - 6 604 843
US - A - 3 970 881
US - A - 4 361 867

(73) Patentinhaber: ROBERT BOSCH GMBH, Postfach 50,
D-7000 Stuttgart 1 (DE)

(72) Erfinder: Hagenlocher, Walter, Galvanistrasse 17,
D-7000 Stuttgart 40 (DE)
Erfinder: Rapp, Lutz, Auberlenweg 7,
D-7000 Stuttgart 1 (DE)
Erfinder: Eschen, Werner, Dipl.-Ing., Wiehenstrasse 19,
D-4515 Bad Essen 2 (DE)
Erfinder: Ragaly, Istvan, Dipl.-Ing.,
Hermann-Essig-Strasse 102, D-7141 Schwieberdingen
(DE)
Erfinder: Scharpf, Heinz, Tulpenweg 18,
D-7064 Remshalden (DE)
Erfinder: Streller, Jörg, Lindenstrasse 66,
D-7151 Affalterbach (DE)
Erfinder: Weigand, Johann, Mittelrain 12,
D-7129 Güglingen (DE)
Erfinder: Winkler, Klaus, Carl-Manch-Weg 5,
D-7141 Freiberg/N. (DE)

## Beschreibung

Die Erfindung betrifft einen Drehstromgenerator für Fahrzeuge mit einem vom Fahrzeugmotor antreibbaren, eine Erregerwicklung tragenden Läufer und mit einem eine Drehstrom-Dreiphasen-Wicklung tragenden, vom Läufer induzierten Ständer und mit einem Dreiphasen-Vollweggleichrichter mit mindestens drei Plusdioden und drei Minusdioden, sowie mit einer sich quer zur Läuferachse erstreckenden Leiterplatte aus Isolierstoff mit in den Isolierstoff eingebetteten Leiterstücken zur Verbindung der Dioden untereinander und mit den Wicklungsteilen, und mit in der Leiterplatte vom Isolierstoff freigehaltenen Aussparungen für die Verbindungsstellen.

Aus der DE-A-3 001 522 ist ein Drehstromgenerator dieser Art bekannt, bei welchem die Verbindungsstellen durch an als Leiterstücke verwendete Kupferdrähte angebogene Schlaufen gebildet sind, welche aus den Aussparungen aus dem Isolierstoff vorstehen. Diese Schlaufen haben jedoch für eine Massenfertigung die Schwierigkeit, daß sie wie geschlossene Ösen wirken, in welche die Enden der Wicklungsdrähte eingefädelt werden müssen, wobei Maßnahmen erforderlich sind, mit denen diese Drahtenden bis zum nachfolgenden Verlöten festgehalten werden können.

Der Erfindung liegt die Aufgabe zugrunde, die an den Aussparungen der Leiterplatte vorgesehenen Verbindungsstellen so auszubilden, daß die abisolierten Wicklungsdrähte eingelegt, verklemmt und verlötet werden können.

Zur Lösung dieser Aufgabe wird erfindungsgemäß vorgeschlagen, daß an den Verbindungsstellen mit den Leiterstücken der Leiterplatte verbundene, U-förmige Anschlußstücke vorgesehen sind, deren das U-bildende Schenkel aus den Aussparungen der Leiterplatte über eine der Oberseiten der Platte vorstehen und einen zum Einklemmen eines Wicklungsdrahtes ausreichenden Abstand voneinander haben.

Die Erfindung ist nachstehend an Ausführungsbeispielen beschrieben, die in der Zeichnung dargestellt sind. Es zeigt

Fig. 1 einen Drehstromgenerator in seinem axialen Längsschnitt und

Fig. 2 in einem nach der Linie II-II in Fig. 1 geführten Querschnitt in der Ansicht auf die dort verwendete Leiterplatte und

Fig. 3 das elektrische Schaltbild des Generators. In den

Fig. 4 bis 11 sind verschiedene Ausführungsformen von erfindungsgemäßen Anschlußstücken dargestellt, wobei jeweils links oben ausschnittsweise in einem senkrecht zur Leiterplatte geführten Schnitt und rechts daneben in einem um 90° gedrehten ebenfalls senkrecht zur Leiterplatte geführten Querschnitt und unter der linken Darstellung in senkrechter Draufsicht auf die Leiterplatte der Grundriß der erfindungsgemäßen Anschlußstücke wiedergegeben ist.

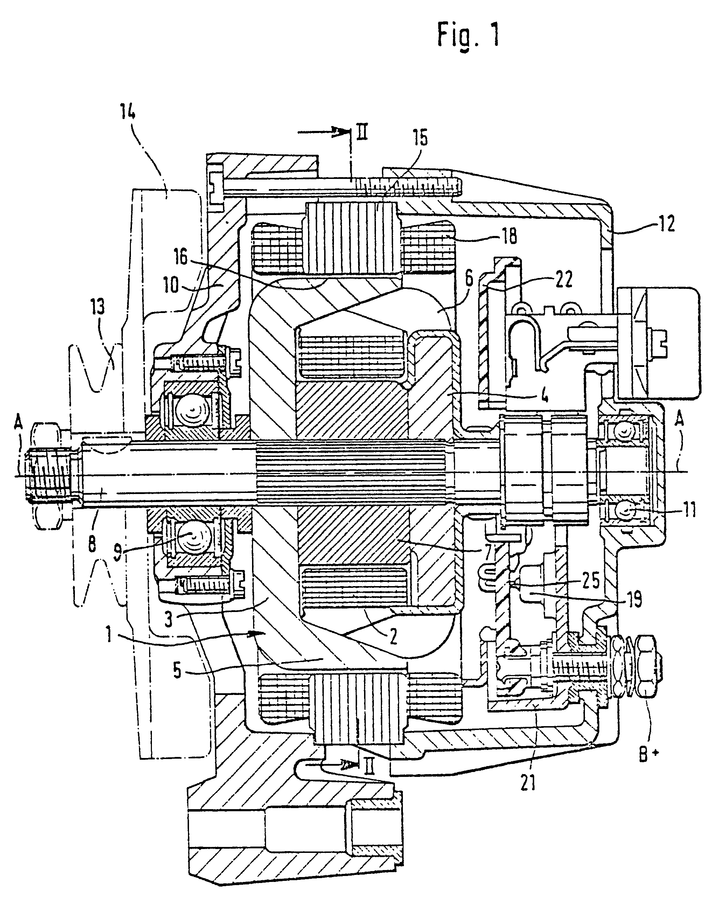

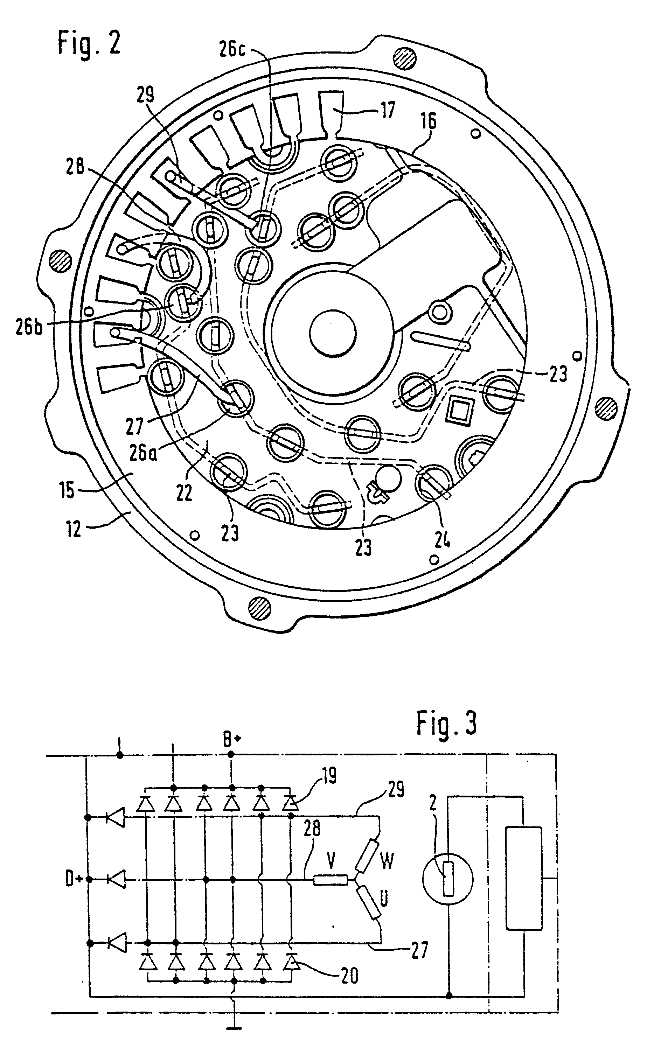

Der in den Fig. 1 und 2 dargestellte Drehstromgenerator ist zum Betrieb auf einem Fahrzeug, insbesondere einem Kraftfahrzeug vorgesehen und enthält einen Klauenpolläufer 1 mit einer Erregerwicklung 2 und zwei Polrädern 3 und 4, die mit fingerförmigen Klauenpolen 5 und 6 ineinander greifen und zusammen mit einem zylindrischen Kern 7 auf der Läuferwelle $\theta$ festsitzen. Diese ist mit einem bei 9 angedeuteten Kugellager in einem vorderen Lagerschild 10 und mit einem zweiten, bei 11 angedeuteten Kugellager in einem rückwärtigen Lagerschild 12 drehbar gelagert und kann mittels einer durch unterbrochene Linien angedeuteten, auf dem aus dem vorderen Lagerschild 10 vorstehenden Wellenende verkeilten Riemenscheibe 13 zusammen mit einem durch einen ebenfalls mit unterbrochenem Linienzug angedeuteten Lüfterrad 14 angetrieben werden.

Quer zu der mit A-A angedeuteten Drehachse des Klauenpolläufers 1 und seiner Läuferwelle 8 ist zwischen den beiden Lagerschilden 10 und 12 ein Ständerblechpaket 15 eingespannt, das in Fig. 2 ausschnittsweise wiedergegeben ist und in seinen gleichmäßig über den Umfang seiner Ständerbohrung 16 verteilten Nuten 17 eine aus drei Phasenwicklungen U, V, W bestehende Drehstromwicklung 18 trägt, welche in Fig. 2 der besseren Deutlichkeit halber nicht wiedergegeben ist. Bei einem Umlauf des Klauenpolläufers 1 werden in den Phasenwicklungen drei jeweils um 120° elektrisch versetzte Wechselspannungen induziert, welche gemäß dem in Fig. 3 dargestellten Schaltplan des Generators in einem hier aus je sechs Plusdioden 19 und sechs Minusdioden 20 bestehenden Gleichrichter gleichgerichtet werden und dann zwischen dem isolierten Pluspol B+ und der Masse des Generators zum Betrieb eines Gleichstrom-Bordnetzes zur Verfügung stehen.

Die Plusdioden 19 (Fig. 3) sitzen auf einem gemeinsamen, in Fig. 1 bei 21 angedeuteten, nierenförmigen Kühlblech, das in der angedeuteten Weise isoliert am Lagerschild 12 befestigt ist, während die Minusdioden 20 auf einem nicht wiedergegebenen, zweiten Kühlblech angeordnet sind, das elektrisch leitend mit dem Lagerschild 12 verbunden ist.

Zwischen diesen Dioden und den sie tragenden Kühlblechen einerseits und dem Polrad 4 andererseits ist eine aus plastischem Isolierstoff formgepreßte Leiterplatte 22 angeordnet, welche mehrere in der Zeichnung teilweise mit unterbrochenen Linien dargestellte Leiterbahnen 23 aus Kupferdraht enthält, wobei diese Leiterbahnen an verschiedenen Aussparungen 24 zur Verbindung der axial und parallel zur Läuferachse verlaufenden Dioden-Anschlußdrähte 25 zugänglich sind. Die drei mit 26a, 26b und 26c bezeichneten Aussparungen weisen Anschlußstücke für den Anschluß der bei 27, 28 und 29 angedeuteten Wicklungsenden der Phasenwicklungen U, V, W auf.

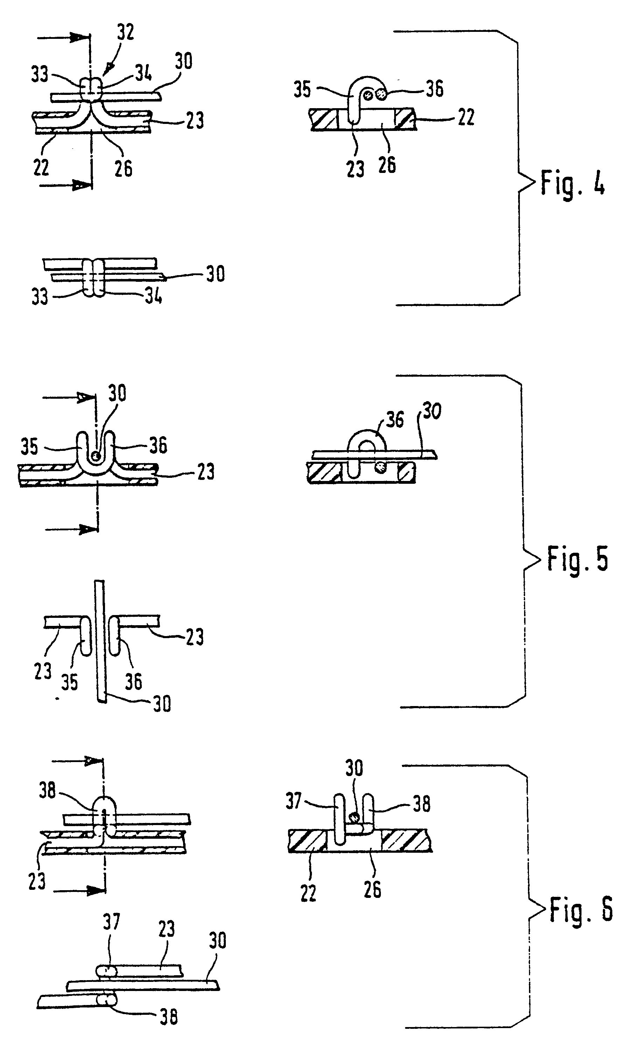

In den Fig. 4 bis 11 sind verschiedene Ausführungsformen für erfindungsgemäß gestaltete Anschlußstücke vorgesehen, welche in Richtung auf die Drehachse gesehen eine U-förmige Gestalt haben, wobei die das U-Profil bildenden Schenkel der Anschlußstücke an der dem Klauenpolläufer zugekehrten Stirnseite der Leiterplatte vorstehen und dort einen geringen gegenseitigen Abstand haben, der gerade ausreicht, daß die Drahtenden 27, 28 und 29 eingeklemmt und bis zum nachfolgenden Verlöten festgehalten werden können.

In den Fig. 4 bis 11 sind die Aussparungen 26a, 26b und 26c stellvertretend mit dem Bezugszeichen 26 angedeutet, und zwar unabhängig von ihrer jeweiligen Lage, weil diese ausschließlich durch die Nähe zu den Wicklungsenden 27, 28 und 29 bestimmt wird.

Bei der Ausführungsform nach Fig. 4 ist das dargestellte Anschlußstück 32 aus dem durchgehenden Abschnitt des Leiter-Drahtes 23 derart hakenförmig gebogen, daß zunächst zwei parallel und eng beieinander liegende Drahtabschnitte 33 und 34 entstehen, die anschließend um eine quer zu diesen Abschnitten sich erstreckende Achse zu einem U-Profil gebogen sind, dessen beide U-Schenkel 35 und 36 einen geringen Abstand voneinander haben, derart, daß dort der generell mit den Bezugszeichen 30 angedeutete, an Stelle der Wicklungsenden 27, 28, 29 eingesetzte Wicklungsanschlußdraht von unten eingelegt, dort mechanisch verklemmt, und so lange festgehalten werden kann, bis er in einem nachfolgenden Lötvorgang endgültig befestigt ist.

Bei dem in Fig. 5 dargestellten Ausführungsbeispiel sind die beiden U-Schenkel ebenfalls mit 35 und 36 und der Wicklungsdraht mit 30 bezeichnet. Dieser kann quer zur Längsrichtung des unverbogenen, wenigstens annähernd geradlinig miteinander verlaufenden Teile des Leiterdrahtes 23 eingelegt werden.

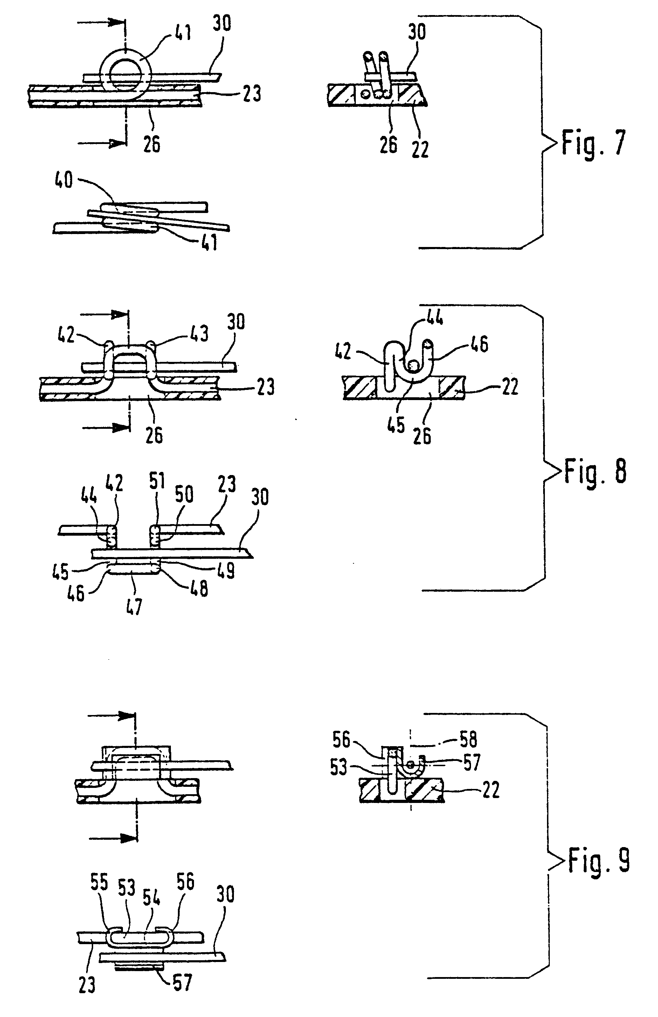

In Fig. 6 ist eine Ausführungsform für die ebenfalls aus dem durchgehenden Leiterdraht 23 geformten, an der Oberseite der Leiterplatte 22 vorstehenden Drahtbügel 37 und 38 dargestellt, welche zusammen das U-Profil bilden, wobei jede der Doppelschleifen 37 und 38 einen von zwei U-Schenkeln bilden, zwischen welche der Wicklungsanschlußdraht 30 eingelegt werden kann.

Bei der Ausführungsform nach Fig. 7 ist der durchgehende Leiterdraht 23 zu zwei parallel zueinander liegenden kreisförmigen Windungen 40 und 41 gewickelt, die eine geringe federelastische Vorspannung gegeneinander haben und daher besonders günstig zum Einklemmen des Wicklungsanschlußdrahtes 30 sind.

Beim Ausführungsbeispiel nach Fig. 8 ist der Leiterdraht 23 der Leiterplatte 22 aus der vorgesehenen Oberseiten-Ebene dieser Leiterplatte zunächst zu zwei in größerem Abstand zueinander stehenden Stützen 42 und 43 hochgebogen, an die sich jeweils ein zweiter Abschnitt 44 anschließt, der in einem Bogenstück 45 bis in die vorgesehene Aussparung 26 hineinreicht und dann wieder in einem senkrechten Abschnitt 46 gemäß der in Fig. 8 angegebenen Seitenansicht in einen Brückenabschnitt 47 übergeht, von welchem in spiegelsymmetrischer Ausbildung ein senkrechter Abschnitt 48 und ein dem ersten Bogenstück 46 entsprechendes zweites Bogenstück 49 weitergeführt, von dem aus der Leitungsdraht 23 in einer senkrechten Stütze 50 und einer zweiten sich an diese eng anschließenden Stütze 51 in die Ebene der unverformten Abschnitte der Leitungsdrähte 23 zurückgebogen ist.

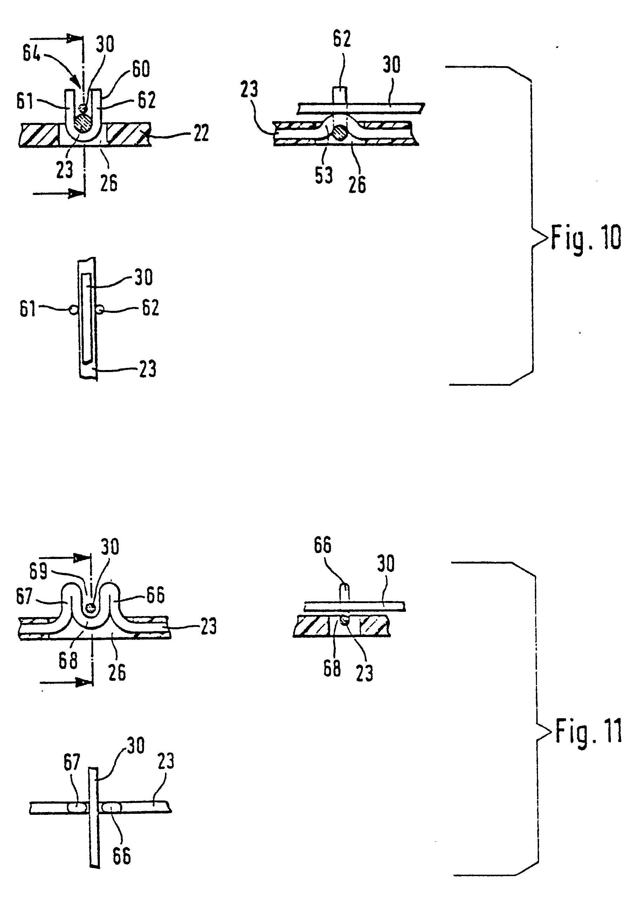

Im Gegensatz zu den seither beschriebenen Ausführungsformen der Anschlußstücke, bei denen jeweils ein verformter Abschnitt der Leiterdrähte 23 das Anschlußstück bildet, ist bei den Ausführungsformen nach den Fig. 9 und 10 ein getrennt hergestelltes Anschlußstück vorgesehen, das auf eine Abkröpfung 53 des Leiterdrahtes 23 im Bereich der Aussparungen 26 aufgesetzt ist.

Beim Ausführungsbeispiel nach Fig. 9 ist ein klammerförmiger Blechstreifen 54 an seinen beiden Streifenenden um die Abkröpfung 53 mit zwei halbkreisförmigen Bogenstücken 55 und 56 so herumgeschlungen, daß das Anschlußstück von oben auf die Abkröpfung auch in fertig gepreßtem Zustand der Leiterplatte 22 aufgeschoben und an der Abkröpfung festgeklemmt und durch Löten oder Schweißen elektrisch leitend mit dem Leiterdraht verbunden werden kann. An das Mittelstück des Blechstreifens 54 ist ein Lappen 57 angeschnitten, der um eine parallel zu dem Leiterdraht 23 und der Abkröpfung 53 verlaufende Achse 58 U-förmig gebogen ist, derart, daß zwischen dem Blechstreifen 54 und dem ebenfalls als U-Schenkel wirkenden Lappen 57 der Wicklungsanschlußdraht 30 eingelegt und festgeklemmt werden kann.

Bei der Ausführungsform nach Fig. 10 steht die Abkröpfung 53 des Leiterbahnendes 23 in fertig verpreßtem Zustand der Leiterplatte 22 nur geringfügig über deren Oberseite vor. Als Anschlußstück ist ein U-förmig vorgebogener Bügel 60 aus im Querschnitt rundem Kupfer- oder Messingdraht vorgesehen, der mit seinen Schenkeln 61 und 62 den Leiterdraht 23 und dessen Abkröpfung 53 umschließt und einen engen Aufnahmeraum 64 für den bei 30 angedeuteten Wicklungsanschlußdraht bildet. Bei dieser Ausführungsform ist es ohne weiteres möglich, den Bügel 60 an der Stelle der jeweiligen Abkröpfung 53 mit dem Leiterbahndraht 23 zu verschweißen oder anderweitig elektrisch leitend am Draht 23 zu befestigen, bevor dieser in die Preßform für die Leiterplatte 22 eingelegt wird. Andererseits besteht jedoch die Möglichkeit, die Leiterplatte ohne Anschlußstücke fertig zu pressen und erst dann den Bügel 60 von unten her durch die Aussparung 26 hindurch über den Leitungsdraht 23 und dessen Abkröpfung so aufzuschieben, daß er das beabsichtigte Anschlußstück für den Wicklungsanschlußdraht 30 bilden kann.

Beim Ausführungsbeispiel nach Fig. 11 ist eine sehr einfach aufgebaute und in einem Durchlaufverfahren für den Leitungsdraht 23 verwendbare Biegevorrichtung vorgesehen. Hier ist nämlich der durchlaufende Leitungsdraht 23 an zwei in kurzem Abstand hintereinander liegende Stellen zu doppelläufigen Schlaufen 66, 67 gefaltet, die untereinander durch ein halbkreisförmiges Bogenstück 68 verbunden sind und mit diesem zusammen ein U-Profil bilden, dessen Schenkel 66 und 67 den Aufnahmeraum 69 für den Wicklungsanschlußdraht 30 begrenzen.

In den Fig. 4, 5, 6, 7, 8 und 9 ist durch Mehrfachanlage des Anschlußdrahtes eine erheblich vergrößerte Lötfläche erzielt. Bei allen Ausführungsformen ergibt die mechanische Klemmwirkung eine zusätzliche Sicherheit für die Lötverbindung.

Für eine Automatisierung des Einlegevorgangs für die Anschlußdrähte 30 bzw. Wicklungsenden 27, 28, 29 und für die Herstellung der Anschlußstücke hat sich das Ausführungsbeispiel nach Fig. 5 als besonders zweckmäßig erwiesen.

## Patentansprüche

1. Drehstromgenerator für Fahrzeuge mit einem vom Fahrzeugmotor antreibbaren, eine Erregerwicklung (2) tragenden Läufer (1) und mit einem eine Drehstrom-Dreiphasen-Wicklung (18) tragenden, vom Läufer induzierten Ständer (15) und mit einem Dreiphasen-Vollweggleichrichter mit mindestens drei Plusdioden (19) und drei Minusdioden (20) sowie mit einer sich quer zur Läuferachse erstreckenden Leiterplatte (22) aus Isolierstoff mit in den Isolierstoff eingebetteten Leiterstücken (23) zur Verbindung der Dioden untereinander und mit den Wicklungsteilen (27—30) und mit in der Leiterplatte vom Isolierstoff freigehaltenen Aussparungen (26a, b, c) für die Verbindungsstellen, dadurch gekennzeichnet, daß an den Verbindungsstellen mit den Leiterstücken (23) verbundene, U-förmige Anschlußstücke (z. B. 32) vorgesehen sind, deren das U-Profil bildende Schenkel aus den Aussparungen über eine der Oberseiten vorstehen und einen zum Einklemmen eines Wicklungsdrahtes ausreichenden Abstand voneinander haben.

2. Generator nach Anspruch 1, dadurch gekennzeichnet, daß an den Verbindungsstellen je eine Abkröpfung aus dem durchgehenden, die Leiterstücke bildenden, blanken Leitungsdraht (23) gebogen ist.

3. Generator nach Anspruch 2, dadurch gekennzeichnet, daß die Abkröpfung (32) mindestens teilweise aus der Aussparung (26, 26a, 26b, 26c) bis über die Oberfläche vorstehend und senkrecht zu dieser verlaufend aus zwei dicht beieinander verlaufenden Drahtabschnitten (33, 34) besteht, die beide hakenförmig um eine parallel zum Leitungsdraht verlaufende Achse gebogen sind (Fig. 4).

4. Generator nach Anspruch 2, dadurch gekennzeichnet, daß zwei die Abkröpfung bildende, quer zum Leitungsdraht (23) sich erstreckende Drahtbügel (35, 36) aus dem Leitungsdraht geformt sind, von denen jeder einen Schenkel des U-Profiles bildet (Fig. 5).

5. Generator nach Anspruch 2, dadurch gekennzeichnet, daß zwei jeweils mit ihrem zugehörigen Leitungsdrahtabschnitt (23) in einer gemeinsamen Ebene liegende Drahtbügel (37, 38) geformt sind.

6. Generator nach Anspruch 5, dadurch gekennzeichnet, daß die Drahtbügel (37, 38) durch ein Zwischenstück verbunden sind, das annähernd senkrecht zu den beiden parallel zueinander und im Abstand voneinander sich erstreckenden Ebenen verläuft (Fig. 6).

7. Generator nach Anspruch 2, dadurch gekennzeichnet, daß die Abkröpfung aus zwei wenigstens annähernd kreisförmigen Windungen (40, 41) des Leitungsdrahtes (23) gebildet ist.

8. Generator nach Anspruch 7, dadurch gekennzeichnet, daß die Windungen (40, 41) parallel zueinander und vorzugsweise mit ihrer Wickelachse quer zur Längsrichtung der sich an die Windungen anschließenden Abschnitte des Leitungsdrahtes (23) stehen.

9. Generator nach Anspruch 5, dadurch gekennzeichnet, daß die zwei eine Abkröpfung bildenden Drahtbügel (66, 67, 68, 69) mit den an die Drahtbügel sich anschließenden Leitungsdrahtabschnitten in einer gemeinsamen Ebene liegen, die etwa senkrecht auf der Oberseite der Leiterplatte (22) steht (Fig. 11).

10. Generator nach Anspruch 2, dadurch gekennzeichnet, daß auf die Abkröpfungen getrennt hergestellte, in sich das U-Profil bildende Anschlußstücke (54, 55, 56, 57 bzw. 61, 62) aufgesetzt sind (Fig. 9 und 10).

11. Generator nach Anspruch 10, dadurch gekennzeichnet, daß die Anschlußstücke aus U-förmig gebogenem Draht (60, 61, 62) bestehen.

12. Generator nach Anspruch 10, dadurch gekennzeichnet, daß die Anschlußstücke aus einem U-förmig gebogenen Blechstreifen (54, 55, 56, 56) bestehen.

13. Generator nach Anspruch 12, dadurch gekennzeichnet, daß an den Blechstreifen angeschnittene Krallen (55, 56) vorgesehen sind.

## Claims

1. Three-phase generator for vehicles, comprising a rotor (1) which can be driven by the vehicle engine and which carries an exciter winding (2), and a stator (15) in which current is induced by the rotor and which carries a three-phase winding (18), and a three-phase full-wave rectifier having at least three positive diodes (19) and three negative diodes (20), and a circuit board (22), which extends transversely to the rotor axis, of insulating material and comprising conductor sections (23), which are embedded in the insulatin material, for connecting the diodes to each other and to the winding sections (27—30), and recesses (26a, b, c) which are kept free of insulating material in the circuit board, for the connecting points, characterised in that U-shaped connecting pieces (for example 32) are provided which are connected to the conductor sections (23) at the connecting points and the legs forming the U-profile project from the recesses over one of the top sides and have a distance from each other which is sufficient for clamping a winding wire.

2. Generator according to claim 1, characterised in that at the connecting points in each case one offset is bent from the continuous bare line wire (23) forming the conductor pieces.

3. Generator according to claim 2, characterised in that the offset (32) consists, projecting at least partially from the recess (26, 26a, 26b, 26c) till over the surface and running parallel to this surface, of two closely adjacent wire sections (33, 34) which are both bent hook-like about an axis running parallel to the line wire (fig. 4).

4. Generator according to claim 2, characterised in that two wire hoops (35, 36), which form the offset and extend transversely to the line wire (23), are formed from the line wire of which each forms one leg of the U-profile (fig. 5).

5. Generator according to claim 2, characterised in that two wire hoops (37, 38) are formed which lie in a common plane with their associated line wire section (23).

6. Generator according to claim 5, characterised in that the wire hoops (37, 38) are connected by an intermediate piece which extends approximately perpendicularly to the two planes extending parallel to each other and at a distance from each other (fig. 6).

7. Generator according to claim 2, characterised in that the offset is formed by two at least approximately circular turns (40, 41) off the line wire (23).

8. Generator according to claim 7, characterised in that the turns (40, 41) are parallel to each other and preferably with their axis of winding tranversely to the longitudinal direction of the sections of the line wire (23) which adjoin the turns.

9. Generator according to claim 5, characterised in that the two wire hoops (66, 67, 68, 69) forming an offset are in a common plane with the line wire sections adjoining the wire hoops, which plane is approximately perpendicular to the top of the circuit board (22) (fig. 11).

10. Generator according to claim 2, characterised in that connection pieces (54, 55,56, 57 and 61, 62), which are separately produced and in themselves form the U-profile, are set onto the offsets (fig. 9 and 10).

11. Generator according to claim 10, characterised in that the connection pieces consists of wire (60, 61, 62) which is bent in the shape of a U.

12. Generator according to claim 10, characterised in that the connection pieces consists of a sheet-metal strip (54, 55, 56, 57) bent in the shape of a U.

13. Generator according to claim 12, characterised in that claws (55, 56) are provided which are cut into the sheet-metal strips.

**Revendications**

1. Alternateur pour véhicule entraîné par un moteur, comportant un rotor (1) portant un enroulement d'excitation (2) et un stator (15) portant un enroulement triphasé (18) pour le courant alternatif, induit par le rotor, et un redresseur pleine-onde triphasé ayant au moins trois diodes positives (19) et trois diodes négatives (20) ainsi qu'une plaque de circuit imprimé (22) disposée transversalement à l'axe du rotor et réalisée en un matériau isolant avec des éléments conducteurs (23) noyés dans la matière isolante pour relier entre elles les diodes et les parties d'enroulement (27–30), ainsi que des découpes (26a, b, c) dégagées dans la matière isolante de la plaque de circuit imprimé pour les points de liaison, caractérisé en ce qu'aux points de liaison avec les éléments conducteurs (23), on a prévu des pièces de raccordement (par exemple 32) en forme de U, dont les branches qui forment le profil en U sont en saillie par rapport à la face supérieure des découpes et ont entre elles une distance suffisante pour pincer un fil d'enrountlement.

2. Alternateur selon la revendication 1, caractérisé en ce qu'aux points de liaison, on a formé une partie recourbée dans le fil conducteur (23), nu, traversant et forme les éléments conducteurs.

3. Alternateur selon la revendication 1, caractérisé en ce que la partie recourbée (32) est au moins partiellement en saillie par rapport aux découpes (26a, 26b, 26c) jusqu'au niveau de la surface supérieure et se compose de deux segments de fil (33, 34) verticaux directement juxtaposés, qui sont tous deux recourbés en vorme de crochets autour d'un axe parallèle au fil conducteur (fig. 4).

4. Alternateur selon la revendication 2, caractérisé en ce que les étriers de fil (35, 36) qui s'étendent transversalement au fil conducteur (23) et qui sont réalisés dans le fil conducteur pour former la partie recourbée, sont respectivement constitués par une branche du profil en U (fig. 5).

5. Alternateur selon la revendication 2, caractérisé en ce que fois deux étriers de fil (37, 38) sont formés avec leurs segments de fil conducteur (23) correspondant dans un plan commun.

6. Alternateur selon la revendication 5, caractérisé en ce que les étriers de fil (37, 38) sont reliés par une pièce intermédiaire qui s'étend pratiquement verticalement par rapport aux deux plans parallèles entre eux et à une certaine distance l'un de l'autre (fig. 6).

7. Alternateur selon la revendication 2, caractérisé en ce que la partie recourbée se compose d'au moins deux spires (40, 41) au moins pratiquement circulaires du fil conducteur (23).

8. Alternateur selon la revendication 7, caractérisé en ce que les spires (40, 41) sont parallèles entre elles et leur axe d'enroulement est de préférence transversal à la direction longitudinale des segments de fil conducteur (23) adjacents à ces spires.

9. Alternateur selon la revendication 5, caractérisé en ce que les deux étriers de fil (66, 67, 68, 69) qui forment une partie recourbée et les segments de fil conducteur adjacents aux étriers de fil sont situés dans un même plan qui est sensiblement perpendiculaire à la face supérieure de la plaque de circuit imprimé (22) (fig. 11).

10. Alternateur selon la revendication 2, caractérisé en ce que sur les parties recourbées, on met des pièces de raccordement (54, 55, 56, 57 et 61, 62), réalisées séparément et qui forment en soi le profil en U (fig. 9 et 10).

11. Alternateur selon la revendication 10, caractérisé en ce que les pièces de raccordement sont réalisées en fil (60, 61, 62) et en forme de U recourbé.

12. Alternateur selon la revendication 10, caractérisé en ce que les pièces de raccordement sont constituées par une bande de tôle (54, 55, 56, 57) courbée en forme de U.

13. Alternateur selon la revendication 12, caractérisé en ce que des griffes (55, 56) sont découpées dans les bandes de tôle.

# Fig. 1

0 088 910

Fig. 2

Fig. 3

Fig. 4

Fig. 5

Fig. 6

Fig. 7

Fig. 8

Fig. 9

Fig. 10

Fig. 11